# EUROPEAN PATENT SPECIFICATION

(11) **EP 1 154 465 B1**
(45) Date of publication and mention of the grant of the patent: **25.08.2004**
(21) Application number: 00204475.8
(22) Date of filing: 19.03.1997
(51) Int. Cl.: H01L 21/00, B29C 45/14

(54) **Device for encapsulating electronic components**
Vorrichtung zum Einkapseln von elektronischen Komponenten
Dispositif d'encapsulation de composants électroniques

(30) Priority: 22.03.1996 NL 1002691
(43) Date of publication of application: 14.11.2001
(62) Divisional of application: 97907480.4
(73) Proprietor: FICO B.V., 6921 RW Duiven (NL)
(72) Inventor: Harmsen, Wilhelmus Hendrikus Johannes, 7031 AM Wehl (NL); Van Haren, Lambertus Franciscus Wilhelmus, 6651 BV Druten (NL); Venrooij, Johannes Lambertus Gerardus Maria, 6922 BM Duiven (NL)
(74) Representative: Van den Heuvel, Henricus Theodorus

(56) References cited:
- EP-A- 0 825 006
- WO-A-97/35703
- US-A- 4 767 302
- US-A- 5 330 347
- PATENT ABSTRACTS OF JAPAN vol. 011, no. 265 (E-535), 27 August 1987 (1987-08-27) -& JP 62 069521 A (MITSUBISHI ELECTRIC CORP), 30 March 1987 (1987-03-30)

## Description

The invention relates to a device for encapsulating electronic components according the preamble of claim 1.

US 5,330,347 discloses a molding press for an injection molding device comprising an upper and a lower mold half being movable with respect to each other. The molding press can accommodate a leadframe containing an integrated circuit. For the molding a plastic material is introduced in a mold cavity by pressing a pellet using a press plunger. For the movement of the plunger use is made of a double construction; a carriage driven by a single leadscrew and on top of the carriage a lever arm driven by an air cylinder. First the carriage is moved upward in a working position and subsequently the working pressure on the plastic is generated by means of the air cylinder.

The present invention has for its object to provide an improved device with which electronic components can be encapsulated with higher speed and with less chance of breakdown, and with an encapsulating device that has a simple construction.

This object is achieved according to the invention by the device as defined in claim 1. Particular embodiments of the invention are the subject of the dependent claims.

The screw spindles are preferably driven by a central motor with interposing of belts. Two screw spindles at a time preferably also support a beam which is displaceable by rotation of the screw spindles and on which at least one plunger is mountable. Instead of using a transfer plate on which the plungers engage, generally with interposing of a plunger block, a plunger displacement using screw spindles according to this invention has the advantage that it takes up very limited space. Another advantage of the centrally driven screw spindles is that this results in an exactly similar placing of the plungers, which in turn results in an improved quality of the encapsulated products.

The Japanese patent JP 62 069521 discloses a cleaner-elevation mechanism to perform the elevation of a cleaner without irregular movement. Use is made of four synchronously rotating screw-shafts with timing belts. However the requirements and functionality for the movement of a cleaner device can and will not be compared with the movement of means for exerting pressure on encapsulating material. US 4 767 302 discloses an exchangeable multiplunger transfer molding die apparatus. A single screw rod drives the movement of the multiplunger unit, there is no disclosure of the use of multiple screw rods in this document.

The present invention will be further elucidated with reference to the non-limitative embodiments shown in the following figures. Herein :
Fig. 1 shows a partly cut-away perspective view of an encapsulating device incorporating the invention, and
Fig. 2 is a perspective view of means for exerting pressure on encapsulating material with four screw spindles.

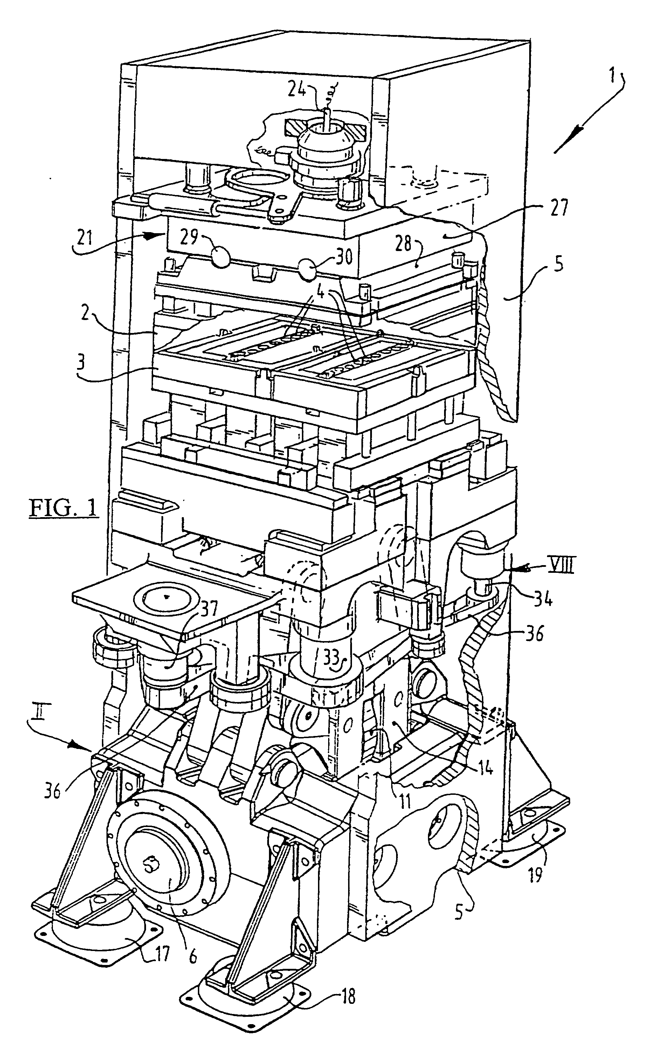

Figure 1 shows an encapsulating device 1 depicted in a pressing position. Fixed in encapsulating device 1 are two mould halves 2, 3 in which the actual encapsulating process takes place. The upper mould halve 2 is partly broken away to give a better view of the lower mould halve 3. In the lower mould halve 3 recesses 4 are visible in which encapsulating material can be placed. By means of plungers not shown in this figure the encapsulating material placed in recesses 4 can then be placed under pressure such that it is urged toward mould cavities likewise not shown in this figure. The lower mould halve 3 is vertically displaceable in a frame 5 of encapsulating device 1 for opening and closing mould halves 2, 3. This opening is necessary for placing of the electronic components for encapsulating, arranging encapsulating material and removing the encapsulated products after the encapsulating operation. Accommodated in the frame 5 of encapsulating device 1 is a geared motor 6 for causing lower mould half 3 to move vertically.

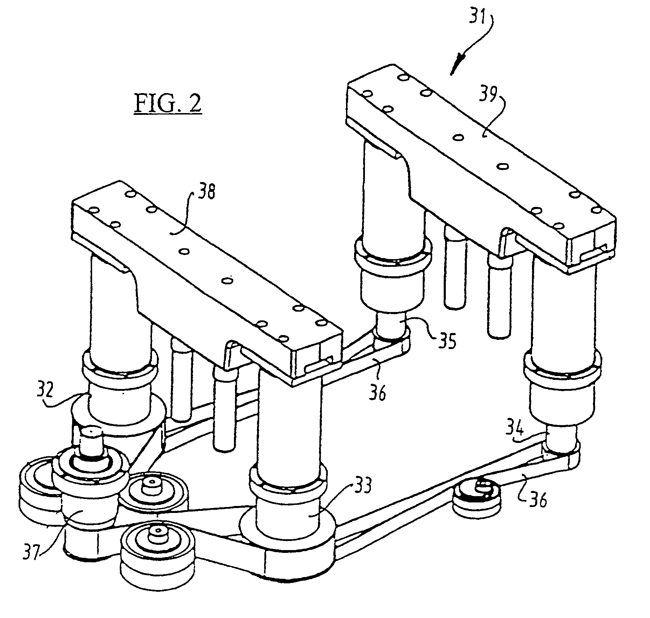

Figure 2 shows the means 31 for exerting pressure on encapsulating material placed in recesses 4. These means are also recognizable in the encapsulating device 1 as shown in figure 1. The means 31 for exerting pressure comprise four vertical screw spindles 32-35 which are driven by a central motor 37 by means of belts 36. By means of rotating screw spindles 32-35 horizontal beams 38, 39 are horizontally displaceable in synchronous manner. Plungers (not shown here) can subsequently engage on these horizontal beams 38, 39, optionally with interposing of other elements such as plunger blocks, which plungers fall into the recesses 4 on the underside of lower mould half 3. By rotating screw spindles 32-35 the encapsulating material placed in recesses 4 can thus be placed under pressure. The means 31 for exerting pressure on the encapsulating material are constructed such that they take up relatively little space in encapsulating device 1.

## Claims

1. Device (1) for encapsulating electronic components, mounted on so-called lead frames, in a mould assembled from two mould halves (2, 3) movable relative to each other and closable onto each other, comprising:
- means (6) for causing the mould halves (2, 3) to move and to close, and
- means (31) for exerting pressure on encapsulating material which can be placed in cavities (4) of the mould,
**characterised in that** the means (31) for exerting pressure on the encapsulating material comprise at least two screw spindles (32, 33, 34, 35) which screw spindles (32, 33, 34, 35) are driven by a central drive (37) and which by rotation of the screw spindles (32, 33, 34, 35) support plunger engaging means (38, 39) for at least one plunger.

2. Encapsulating device (1) as claimed in claim 1, **characterised in that** the screw spindles (32, 33, 34, 35) are driven by a central motor (37) with interposing of belts (36).

3. Encapsulating device (1) as claimed in claim 1 or 2, **characterised in that** two screw spindles (32, 33, 34, 35) at a time support a beam (38, 39) which is displaceable by rotation of the screw spindles (32, 33, 34, 35) and on which at least one plunger can engage.

## Patentansprüche

1. Vorrichtung (1) zum Einkapseln von elektronischen Komponenten, die auf sogenannten Leiterrahmen montiert sind, in einem Formwerkzeug, das aus zwei Formhälften (2,3) zusammengesetzt ist, die relativ zueinander bewegen und aufeinander geschlossen werden können, bestehend aus:
- Mitteln (6), die die Bewegung und das Schließen der Formhälften (2, 3) veranlassen, und
- Mitteln (31) zur Ausübung von Druck auf Einkapselungsmaterial, das in Hohlräume (4) der Form eingebracht werden kann,
**dadurch gekennzeichnet, dass** die Mittel (31) zur Ausübung von Druck auf das Einkapselungsmaterial mindestens zwei Schraubenspindeln (32, 33, 34, 35) umfassen, welche Schraubenspindeln (32, 33, 34, 35) von einem zentralen Antrieb (37) angetrieben werden und welche aufgrund der Rotation der Schraubenspindeln (32, 33, 34, 35) Mittel (38, 39), die mit Druckkolben in Eingriff stehen, für mindestens einen Druckkolben abstützen.

2. Vorrichtung (1) zum Einkapseln nach Anspruch 1, **dadurch gekennzeichnet, dass** die Schraubenspindeln (32, 33, 34, 35) von einem zentralen Motor (37) unter Zwischenschaltung von Riemen (36) angetrieben werden.

3. Vorrichtung (1) zum Einkapseln nach Anspruch 1 oder 2, **dadurch gekennzeichnet, dass** zwei Schraubenspindeln (32, 33, 34, 35) gleichzeitig einen Träger (38, 39) abstützen, welcher aufgrund der Rotation der Schraubenspindeln (32, 33, 34, 35) verstellt werden kann und an dem mindestens ein Druckkolben angreifen kann.

## Revendications

1. Dispositif (1) pour encapsuler des composants électroniques, montés sur ce qu'il est convenu d'appeler des grilles de connexion, dans un moule assemblé à partir de deux moitiés de moule (2, 3) déplaçables relativement l'une à l'autre et pouvant être fermées par application l'une sur l'autre, comprenant :
- des moyens (6) pour faire se déplacer et se fermer les moitiés de moule (2, 3), et
- des moyens (31) pour exercer une pression sur du matériau d'encapsulation qui peut être placé dans des cavités (4) du moule,
**caractérisé en ce que** les moyens (31) pour exercer une pression sur le matériau d'encapsulation comprennent au moins deux tiges filetées (32, 33, 34, 35), lesquelles tiges filetées (32, 33, 34, 35) sont entraînées par un entraînement central (37) et qui, par rotation des tiges filetées (32, 33, 34, 35), supportent des moyens d'appui de piston plongeur (38, 39) pour au moins un piston plongeur.

2. Dispositif d'encapsulation (1) selon la revendication 1, **caractérisé en ce que** les tiges filetées (32, 33, 34, 35) sont entraînées par un moteur central (37) avec interposition de courroies (36).

3. Dispositif d'encapsulation (1) selon la revendication 1 ou 2, **caractérisé en ce que** deux tiges filetées (32, 33, 34, 35) à la fois supportent une traverse (38, 39) qui est déplaçable par rotation des tiges filetées (32, 33, 34, 35) et sur laquelle au moins un piston plongeur peut prendre appui.
